Europäisches Patentamt

(19) European Patent Office

Office européen des brevets

(11) Publication number: **0 153 868**
A2

(12) **EUROPEAN PATENT APPLICATION**

(21) Application number: **85301381.1**

(22) Date of filing: **28.02.85**

(51) Int. Cl.⁴: **H 03 C 3/09**
**H 03 L 7/18**

(30) Priority: **29.02.84 US 584668**

(43) Date of publication of application:
**04.09.85 Bulletin 85/36**

(84) Designated Contracting States:
**DE FR GB NL**

(71) Applicant: **Hewlett-Packard Company
Mail Stop 20 B-O 3000 Hanover Street
Palo Alto California 94304(US)**

(72) Inventor: **Curtis, G. Stephen
E. 11722 37th Avenue
Spokane Washington 99209(US)**

(72) Inventor: **Whipple, David P.
7620 South Linke
Greenacres Washington 99016(US)**

(74) Representative: **Squibbs, Robert Francis
Hewlett-Packard Limited Nine Mile Ride
Wokingham Berkshire RG11 3LL(GB)**

(54) FM calibration in a phase-locked loop.

(57) Apparatus is provided for effecting calibrated frequency modulation (FM) of frequencies generated in a phase-locked loop. A phase-locked loop (PLL) includes a voltage-controlled oscillator VCO which is locked to a loop reference signal frequency. Whenever the loop frequency is changed a calibration cycle is initiated in which a modulo- 9/10 divider (22) included in the loop is operated to add integral multiples of two pi radians of phase to the output signal of the VCO. This forces the PLL to step change the loop frequency by an integral multiple of the reference frequency. A sampling circuit (20,24) senses and measures the change in the loop frequency. The change in the control voltage is a measure of the VCO gain at that frequency. The change in the control voltage is converted to a digital number which is loaded into a multiplying digital-to-analog converter (DAC) inserted in the PLL to adjust the gain of the DAC. The effective combined gain of the DAC and the VCO is constant and independent of the VCO gain over the entire range of the VCO thereby providing an equal amount of modulation from an FM signal at any frequency of the VCO.

FIG. 1

1

## FM CALIBRATION IN A PHASE-LOCKED LOOP

The invention relates generally to frequency modulation of an RF carrier and more particularly to frequency modulation calibration in a phase-locked loop.

It is well known in the art to synthesize frequencies by means of phase-locked loop circuits. The phase-locked loop (PLL) includes a tunable oscillator (typically a voltage-controlled oscillator (VCO)) whose output is locked to a known reference signal by means of a phase comparator. The phase comparator generates an output voltage or current that is proportional to the phase difference between the two signals. The phase comparator output is fed back to the input of the VCO and used to tune the VCO. This forces the VCO output to have exactly the same frequency as the reference signal. By interposing a divide-by-N block in the circuit comparator, the reference frequency may instead be compared with the VCO frequency divided by N; the VCO output will then be locked to N times the reference frequency. By varying N, it is possible to generate frequencies which are the Nth harmonics of the reference frequencies, where N is an integer. Another technique, called fractional N, makes it possible to generate frequencies that are any rational multiple of the reference frequency. Such a technique is disclosed in U. S. Patent No. 3,928,813 issued to Charles A. Kingsford-Smith on December 23, 1975, entitled "Device for Synthesizing Frequencies which are Rational Multiples of a Fundamental Frequency".

In some applications, it is often desired to frequency modulate (FM) the synthesized signal. A PLL is in effect a control system that maintains a constant phase difference between two signals. Any variations in the phase of one signal relative to the other are removed by the PLL. This property of a PLL is utilized to suppress noise and clean up a signal; however, this property also tends to suppress frequency modulation of a signal in PLL.

Audio FM may be accomplished by splitting the FM (Frequency Modulating) signal into two separate signal paths. One path is AC-coupled to the VCO and will be the primary path for the FM signal for frequencies that are above the bandwidth of the PLL. FM at frequencies inside the PLL bandwidth is integrated and then injected into a summing node at the output of the phase detector. Since phase is the integral of frequency, FM at frequencies within the PLL bandwidth is accomplished by phase modulation (PM). Properly scaling the gains of each signal path provides flat FM response both inside and outside the PLL bandwidth.

One of the primary problems encountered when frequency modulating a signal in a PLL is that the gain of the VCO is not constant -- generally the gain of the VCO varies with the frequency of the VCO. One solution to this problem is to FM only at a single VCO frequency. Another solution injects an FM calibration signal into the loop through a variable-gain amplifier, then the gain of the amplifier is varied to match the frequency demodulated VCO output signal to a reference signal.

It is an object of the present invention to provide FM calibration circuitry enabling calibrated frequency modulation (FM) in a PLL (that is, at different frequencies of the VCO, the same FM input signal will produce substantially the same amount of modulation of the output signal).

Formally stated, the present invention provides apparatus for effecting calibrated frequency modulation of a multiplicity of frequencies which are desired multiples of a reference frequency generated in a phase-locked loop, said apparatus including a phase-locked loop comprising frequency generating means for producing an output signal with a frequency determined by the level of a control input signal; counting means coupled to the output of the frequency generating means for producing an output signal having a frequency equal to the frequency of the signal at the input of the counting means dividied by N; phase comparison means coupled to the counting means for comparing the phases of the output signal from the counting means and the reference signal, and generating an error signal indicative of a phase difference therebetween, said error signal serving as the control input signal to the frequency generating means to thereby control the frequency of the output signal from the frequency generating means; and input summing means coupled to the output of the phase comparison means and to the input of the frequency generating means for summing a frequency modulation signal with the control input signal for producing frequency modulation of the output signal from the frequency generating means; characterized in that said apparatus further includes frequency calibration means comprising:

frequency change means coupled to the counting means, and responsive to a frequency step-change signal to change the frequency of the input signal to the counting means thereby forcing the phase-locked loop to step change the frequency of the frequency generating means output signal by a multiple of the reference signal frequency;

sampling means coupled to the input of the frequency generating means for detecting a change in the control input signal and providing an output signal linearly proportional to said change in the control input voltage; and

amplitude adjustment means coupled to the sampling means and responsive to the output of the sampling means for adjusting the amplitude of the frequency modulation signal, said adjustment of the amplitude of the frequency modulation signal being proportional to the output of the sampling means.

The effect of the FM calibration circuitry is to make the VCO gain (which is a function of frequency) to seem to be constant as seen by the PLL.

In apparatus as set forth in the last preceding paragraph but one, said frequency change means preferably comprises phase shift means, interposed between the frequency generating means and the counting means, for shifting the phase of the input signal to the counting means by a multiple of two pi radians of phase thereby forcing the phase-locked loop to step-change the frequency of the frequency generating means output signal by said multiple of the reference signal.

In apparatus as set forth in the last preceding paragraph, said phase shift means can comprise cycle addition means for adding at least one cycle to the input of the counting means thereby adding a multiple of two pi radians of phase to the input signal to the counting means.

In apparatus as set forth in the last preceding paragraph, the said cycle addition means can comprise a divide-by-two flip-flop coupled to a three-modulus prescaler.

In apparatus as set forth in any one of the last five preceding paragraphs, said sampling means preferably comprises a capacitor coupled to the ground through an electronic switch, said capacitor serving to detect said change in the control input signal level.

In apparatus as set forth in the last preceding paragraph, the sampling means preferably also comprises an analog-to-digital converter coupled to said capacitor and to the amplitude adjustment means, said analog-to-digital converter being arranged to convert said change in the control input signal level to a digital signal indicative of said change in the control input signal level.

In apparatus as set forth in the last preceding paragraph, said amplitude adjustment means preferably comprises a variable-gain amplifier responsive to said digital signal to amplify the amplitude of the frequency modulation signal in proportion to said digital signal.

In apparatus as set forth in the last preceding paragraph, the said variable-gain amplifier preferably comprises a multiplying digital-to-analog converter interconnected between said input summing means and said frequency generating means, said digital signal adjusting the gain of said multiplying digital-to-analog converter.

In apparatus as set forth in the last preceding paragraph, said amplitude adjustment means preferably further includes a voltage offset circuit coupled to the output of the multiplying digital-to-analog converter for providing an offset voltage, said offset voltage being summed with the output of the digital-to-analog converter, the level of said offset voltage being determined by the frequency of the frequency generating means output signal.

In one preferred embodiment to be more fully described hereinafter, the apparatus comprises a PLL formed by a VCO, a divide-by-two circuit, a three-modulus prescaler, a divide-by-N circuit, a phase difference detector, and an AC coupled signal path for FM that is outside the loop bandwidth. In this PLL, a frequency calibration cycle is initiated by changing the modulus of the prescaler from ten to nine and back again in such a manner that the divide-by-N circuit sees two additional cycles of phase (four pi radians) per reference period. The addition of two cycles per reference period will cause the loop step to change its frequency by 200 kHz (where the PLL utilizes a reference signal frequency of 100 kHz).

A sample circuit is then used to sample the change in the VCO input control voltage caused by the step change in frequency. The change in the control voltage over a frequency step of 200 kHz provides a precise measure of the gain of the VCO at the particular frequency that the PLL is locked to (a rational multiple of the reference signal frequency). The voltage change is next amplified and scaled by an amplifier and an analog-to-digital converter (A/D), then loaded into a multiplying digital-to-analog converter (DAC) interposed between the phase difference detector and the VCO whereby to provide a calibrated VCO input control signal to compensate for the VCO gain at that particular VCO frequency. Each time the PLL frequency is changed, a calibration cycle is initiated and the gain of the DAC reset.

The above-described preferred embodiment utilizes the characteristics of the PLL to effectively shift the loop frequency a step change of 200 kHz. Every time the loop frequency is changed, the VCO gain at the new frequency is measured and the gain of the multiplying DAC resets which maintains the combined gain of the DAC and the VCO constant over the entire frequency range of the VCO. Use of the loop itself to generate the step change in loop frequency eliminates the need for separate circuitry to generate the test signal required to measure VCO gain. Further, maintaining the VCO gain effectively constant over the frequency range improves the PLL stability and noise performance.

There now follows a detailed description which is to be read with reference to the accompanying drawings of an FM phase-locked loop (PLL) provided with FM calibration circuitry; it is to be understood that the PLL and calibration circuitry have been selected for description to illustrate the invention by way of example and not by way of limitation.

In the accompanying drawings:-

Figure 1 is a block diagram of the phase-locked loop and FM calibration circuitry;

Figure 2 is a schematic diagram of the FM calibration circuitry utilized in the phase-locked loop illustrated in Figure 1;

Figure 3 is a timing diagram illustrating timing signals which control the basic sequence of events during an FM calibration cycle.

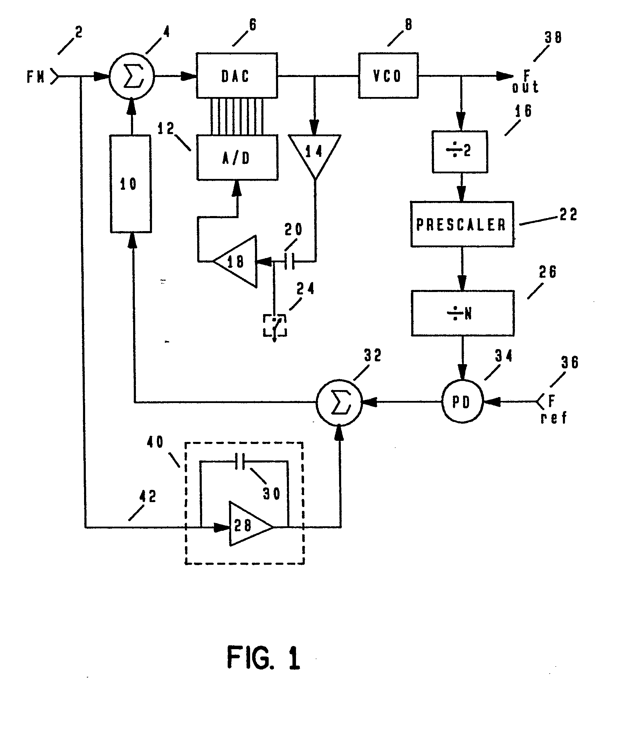

The FM phase-locked loop (PLL) shown in Figure 1 includes a voltage-controlled tunable oscillator (VCO) 8, a phase detector 34 and a loop filter 10. An FM signal input at 2 is summed in summing block 4 with the output of the loop filter 10. The output of the summing block 4 is scaled by an amplifier with digitally-settable gain, this amplifier being constituted in the present embodiment by a multiplying digital-to-analog converter (DAC) block 6. The output of the block 6 is used as the control voltage input to the VCO 8. The output frequency, $F_{out}$ 38, of the VCO 8 is divided down firstly by a divide-by-two flip-flop 16, then by a three-modulus prescaler 22 and finally by a frequency divider 26, the latter effecting division by a pre-settable number N. The phase of the divider output is compared with the phase of a 100 kHz reference signal, $F_{ref}$ 36 in the phase detector 34. The frequency divider (divide-by-N block) 26 is constituted by an electronic counting circuit and allows the PLL to be locked to any rational multiple of the frequency of the reference signal 36. The output of the phase detector 34 is a voltage that is proportional to the difference in phase between its inputs. An OP-AMP 28 and a capacitor 30 form an integrator 40 which integrates the FM input signal, the latter being fed thereto on line 42. The integrator 40 provides a phase modulation (PM) voltage signal to a summing block 32 where the PM voltage signal is summed with the output voltage of the phase detector 34.

For a given loop frequency step change (dF), the change in the VCO control voltage (dV) is proportional to the reciprocal of the VCO gain ($K_{VCO}$):

$$dV \text{ (Volts)} = dF(Hz)/K_{VCO}(Hz/Volt).$$

In order to calibrate the phase-locked loop, the loop is forced to step change its frequency by an amount dF. The control voltage step change dV resulting is then measured by a sampling circuit comprised of a buffer amplifier 14, a capacitor 20, an electronic switch 24, and an amplifier 18. The voltage change is converted into a binary number by an A/D converter 12 and loaded into the multiplying DAC 6 to adjust the gain of the DAC in proportion to the magnitude of dV. Expressing the gain of the DAC as K.dV where K is a constant, the effective gain ($K_v$) of the DAC 6 and the VCO 8 is given by:

$$K_v = (KdV)K_{VCO} = K(dF/K_{VCO})K_{VCO} = KdF$$

The effective gain of the DAC 6 and the VCO 8 is thus independent of the VCO gain $K_{VCO}$.

Each time the loop frequency is changed to a new loop frequency (greater than 200 kHz away from the previous loop frequency), an FM calibration cycle is initiated. The value of N appropriate to the desired frequency ($F_d$) is loaded into the divide-by-N block 26 and at the same time a frequency step change signal directs the prescaler 22 to change its modulus from ten to nine and from nine back to ten each reference period such that the combined effect of the divide-by-two flip-flop 16 and the prescaler 22 is to add two cycles of phase (four pi radians) per reference period to the output signal, whereupon $F_{out}$, 38 of the VCO 8 and the PLL will go to the $F_d$ plus 200 kHz.

The VCO control voltage on line 7 is sensed by the buffer amplifier 14, the output of which is applied to the sampling capacitor 20. The electronic switch 24 is closed during this time allowing the capacitor 20 to charge to the control voltage on line 7. When the loop has settled to within 1 kHz of the final frequency ($F_d$ plus 200 kHz), the electronic switch 24 is opened and the prescaler modulus is changed back from nine to ten. The result is that the loop now locks to the desired frequency, $F_d$. The sampling capacitor 20 sees the change in the control voltage on line 7 and this change is amplified by the amplifier 18 and inputted to the analog-to-digital converter (A/D) 12.

The change in control voltage on line 7 seen by the capacitor 20 exactly equals 200 kHz/$K_{VCO}$.

The minimum VCO gain, $K_{VCO}$, is approximately 2.6 MHz/Volt, therefore the maximum VCO control voltage change, dV, for a 200 kHz step will be 80 millivolts. The gain of the amplifier 18 coupled to the sampling capacitor 20 is scaled such that at least 90% of the full scale of the A/D converter 12 is utilized. The analog to digital conversion is accomplished immediately after the loop has settled to the desired frequency, $F_d$. The digital number proportional to the control voltage step change is loaded into the DAC 6 to reset the gain of the DAC 6. Once the loop has corrected for any transients produced by resetting the DAC 6 gain, the FM calibration cycle is complete.

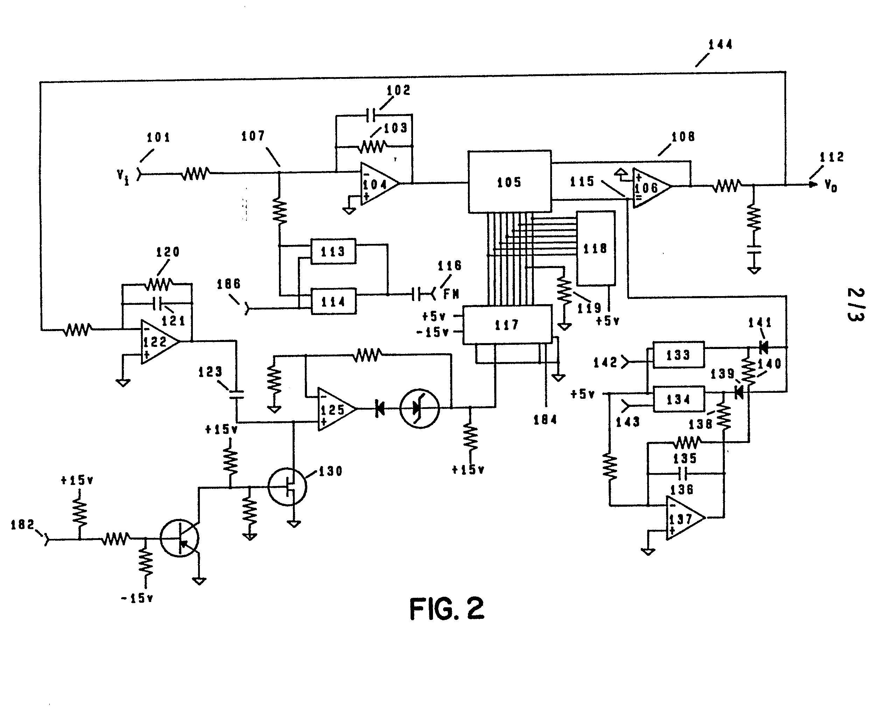

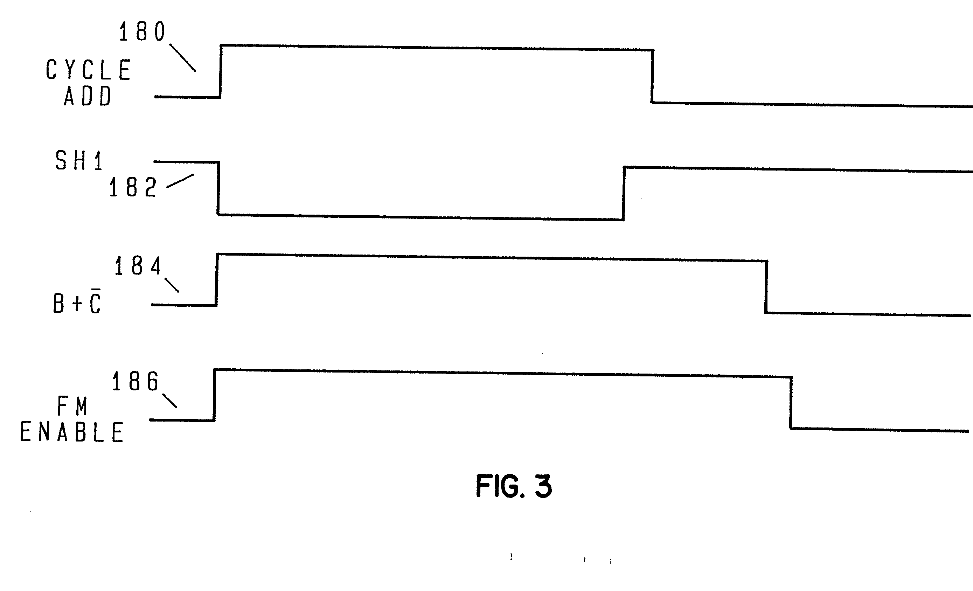

The calibration circuitry of the phase-locked loop will now be described in more detail with reference to Figure 2. In this Figure, the summing block 4 of Figure 1 is constituted by an inverting summing amplifer formed by an OP-AMP 104, a resistor 103, and a capacitor 102. This summing amplifier has a summing node 107 to which the FM input signal 116 (referenced 2 in Figure 1) is fed via CMOS switches 113 and 114. The switches 113 and 114 are controlled by an FM enable signal 186 (as shown in Figure 3). The output of the loop filter (shown as 10 on Figure 1), $V_i$ 101, is summed with the FM signal 116 at the summing node 107 and the summed signal is amplified by the OP-AMP 104 before being input to a DAC 105 constituting the core of the DAC block 6 of Figure 1. The DAC 105 is a CMOS DAC which internally switches currents in an R-2R ladder either to ground or to the summing node 115 of an inverting amplifier 106. The DAC 105 also includes a feedback resistor (not shown) connected by a line 108 between the output of the inverting amplifier 106 and the summing node 115. The DAC 105 setting is loaded directly from the output lines of a A/D converter 117 that corresponds to the heart of the A/D

0153868

converter 12 of Figure 1. During most of the FM calibration cycle, a timing signal 184 (as shown in Figure 3) forces the A/D converter 117 outputs to a tri-state mode. This results in the gain of the DAC 105 being set to 0.75 due to all its input data lines, except the second most significant digit, being pulled high by the pull up resistors in resistor array 118, the second most significant digit line being pulled low by resistor 119. Setting the DAC to a gain of 0.75 assures that the loop will be stable during frequency changes of the loop.

An OP-AMP 122, resistor 120 and capacitor 121 comprise an inverting amplifier which serves as a buffer with a gain of one to sense the VCO control voltage, $V_0$ 112, on the line 144 (this buffer corresponds to the buffer 14 of Figure 1). The sampling capacitor 123 (shown as capacitor 20 in Figure 1) is connected to the output of the buffer amplifier 122 and couples the change in VCO control voltage resulting from a loop frequency step change of 200 kHz. At the start of an FM calibration cycle, a sample-hold signal 182 (as shown in Figure 3) goes low, causing an FET 130 to switch one side of the capacitor 123 to ground and thereby allowing it to charge to the VCO control voltage on the line 144. Once the loop has settled to $F_d$ plus 200 kHz, the sample-hold signal 182 goes high, opening the switch comprising the FET 130; thereafter, the loop frequency is step changed to $F_d$. The capacitor 123 now sees a new control voltage on the line 144 and couples the change in the control voltage resulting from the step change in loop frequency of 200 kHz to a differential amplifier 125 that corresponds to the amplifer 18 of Figure 1.

The output of the amplifier 125 is input to the A/D converter 117 as a Blank and Not Convert signal ($B+\bar{C}$) as shown in Figure 3). At the start of an FM calibration cycle, the $B+\bar{C}$ signal 184 goes high, forcing the output of the A/D converter 117 to go to a tri-

11

state mode allowing the resistor array 118 and the resistor 119 to set the gain of DAC 105 to 0.75. When the B+C̄ signal goes low, the change in VCO control voltage input from the amplifier 125 is converted to a digital number and loaded into the DAC 105 to adjust its gain.

At a VCO frequency of 60 MHz, the VCO has maximum gain ($K_{VCO}$) requiring a DAC gain setting of about 0.5. At 60 MHz, the VCO requires a control voltage of 10 volts which would require an input voltage to the DAC 105 of 20 volts which is greater than the output voltage of OP-AMPs in the circuit. To meet this situation, a switchable current source is provided which inputs an offset current as a function of the loop frequency to the summing node 115 to be summed with the output of the DAC 105. This switchable current source comprises two electronic switches 133, 134, and OP-AMP 137, a resistor 135, a capacitor 136, resistors 138 and 140, and diodes 139 and 141. The electronic switches 133 and 134 sense the loop frequency supplied thereto on lines 142 and 143. At a loop frequency of 60 MHz, the output of the switches 133 and 134 are both open, allowing current to flow through both resistors 138 and 140. The resistor 138 is arranged to cause a 6 volt offset at the output of the summing amplifier 106, while the resistor 140 is arranged to cause a 3 volt offset at the output of the summing amplifier 106; together the resistors 138 and 140 will cause a 9 volt offset at the output of the summing amplifier 106. Therefore, if at 60 MHz a 9 volt offset is provided at the output of summing amplifier 106, the input voltage to the DAC 105 need then only be 2 volts to provide a control voltage of 10 V to the VCO.

Depending on the loop frequency, neither, one, or both of the switches 133 and 134 will be open in order to produce the offset, if any, required at the output of the summing amplifier 106.

Referring now to Figure 2 and Figure 3, whenever it is desired to tune the PLL to a new frequency, $F_d$, an FM calibration cycle is initiated by a host microprocessor (not shown) and the timing signals illustrated in Figure 3 are generated. When the desired frequency, $F_d$, is loaded into the host microprocessor, a new number N is generated to be used by the divide-by-N block 26 (as shown in Figure 1) to force the loop to the new frequency $F_d$. At the same time, an FM enable signal 186 goes high, opening the CMOS switches 113 and 114 to interrupt the FM signal 116 path; the blank and not convert $(B+\bar{C})$ 184 signal goes high forcing the A/D converter 117 output to go tri-state which sets the gain of the DAC 105 at 0.75; the sample signal (SH1) 182 goes low, grounding the sampling capacitor 123 through the FET 130; and an 'add cycle' signal 180 that controls the prescaler 22 (Figure 1) goes high, changing the modulus of the prescaler 22 from ten to nine. When the loop has settled to $F_d$ plus 200 kHz, the signal SH1 182 goes high, holding the tune voltage on the capacitor 123. When the 'cycle add' signal 180 goes low, the prescaler 22 modulus is permanently changed from nine back to ten and the loop settles at $F_d$. The differential tune voltage resulting from the 200 kHz step change is now on the sampling capacitor 123 and is scaled by the amplifier 125 and input to the A/D converter 117. The signal $B+\bar{C}$ 184 now goes low, the A/D converter output is no longer tri-state and the differential tune voltage is converted to a digital number and loaded into the DAC 105 resetting the gain of the DAC 105 from 0.75 to the required new gain. When the loop transients resulting from the new gain setting are compensated for, the signal FM enable 186 goes low, closing the CMOS switches 113 and 114, and the FM calibration cycle is complete.

Claims

1. Apparatus for effecting calibrated frequency modulation of a multiplicity of frequencies which are desired multiples of a reference frequency generated in a phase-locked loop, said apparatus including a phase-locked loop comprising:

frequency generating means (8) for producing an output signal with a frequency determined by the level of a control input signal;

counting means (26) coupled to the output of the frequency generating means (8) for producing an output signal having a frequency equal to the frequency of the signal at the input of the counting means (26) divided by N;

phase comparison means (34) coupled to the counting means (26) for comparing the phases of the output signal from the counting means (26) and the reference signal ($F_{ref}$), and generating an error signal indicative of a phase difference therebetween, said error signal serving as the control input signal to the frequency generating means (8) to thereby control the frequency of the output signal from the frequency generating means (8); and

input summing means (4) coupled to the output of the phase comparison means (34) and to the input of the frequency generating means (8) for summing a frequency modulation signal (FM) with the control input signal for producing frequency modulation of the output signal from the frequency generating means (8);

characterized in that said apparatus further includes frequency calibration means comprising:

frequency change means (16,22) coupled to the counting means (26), and responsive to a frequency step change signal to change the frequency of the input signal to the counting means (26) thereby forcing the phase-locked loop to step change the frequency of the frequency generating means (8) output signal by a multiple of the reference signal

0153868

frequency;

sampling means (20,24,12) coupled to the input of the frequency generating means (8) for detecting a change in the control input signal and providing an output signal linearly proportional to said change in the control input voltage; and

amplitude adjustment means (6) coupled to the sampling means (20,24,12) and responsive to the output of the sampling means for adjusting the amplitude of the frequency modulation signal, said adjustment of the amplitude of the frequency modulation signal being proportional to the output of the sampling means (20,24,12).

2. Apparatus according to Claim 1, wherein said frequency change means comprises phase shift means (16,22) interposed between the frequency generating means (8) and the counting means (26), for shifting the phase of the input signal to the counting means (26) by a multiple of two pi radians of phase thereby forcing the phase-locked loop to step change the frequency of the frequency generating means output signal by said multiple of the reference signal.

3. Apparatus according to Claim 2, wherein said phase shift means comprise cycle addition means (16,22) for adding at least one cycle to the input of the counting means thereby adding a multiple of two pi radians of phase to the input signal to the counting means.

4. Apparatus according to Claim 3, wherein said cycle addition means comprise a divide-by-two flip-flop (16) coupled to a three-modulus prescaler (22).

5.     Apparatus according to any one of the preceding claims, wherein said sampling means comprises a capacitor (20) coupled to ground through an electronic switch (24), said capacitor (20) serving to detect said change in the control input signal level.

6.     Apparatus according to Claim 5, wherein said sampling means further comprises an analog-to-digital converter (12) coupled to said capacitor (20) and to the amplitude adjustment means (6), said analog-to-digital converter (12) being arranged to convert said change in the control input signal level to a digital signal indicative of said change in the control input signal level.

7.     Apparatus according to Claim 6, wherein said amplitude adjustment means comprises a variable-gain amplifier (6) responsive to said digital signal to amplify the amplitude of the frequency modulation signal in proportion to said digital signal.

8.     Apparatus according to Claim 7, wherein said variable-gain amplifier comprises a multiplying digital-to-analog converter (6) interconnected between said input summing means (4) and said frequency generating means (8), said digital signal adjusting the gain of said multiplying digital-to-analog converter (6).

9.     Apparatus according to Claim 8, wherein said amplitude adjustment means further includes a voltage offset circuit coupled to the output of the multiplying digital-to-analog converter (6) for providing an offset voltage, said offset voltage being summed with the output of the digital-to-analog converter (6), the level of said offset voltage being determined by the frequency of the frequency generating means output signal.

1/3

FIG. 1

0153868

FIG. 2

2/3

0153868

0153868

3/3

FIG. 3

CYCLE ADD  180

SH1  182

B+C̄  184

FM ENABLE  186